# FASCICULE DE BREVET EUROPEEN

(11) **EP 4 165 721 B1**
(45) Date de publication et mention de la délivrance du brevet: **17.07.2024**
(21) Numéro de dépôt: 21730955.8
(22) Date de dépôt: 09.06.2021
(51) Int. Cl.: H01P 5/20

(54) **SYSTÈME COMBINEUR DE PUISSANCE COMPRENANT QUATRE AMPLIFICATEURS DE PUISSANCE HYPERFRÉQUENCES À ÉTAT SOLIDE**
LEISTUNGSKOMBINIERERSYSTEM MIT VIER FESTKÖRPER-MIKROWELLENLEISTUNGSVERSTÄRKERN
POWER COMBINER SYSTEM COMPRISING FOUR SOLID-STATE MICROWAVE POWER AMPLIFIERS

(30) Priorité: 11.06.2020 FR 2006098
(43) Date de publication de la demande: 19.04.2023
(73) Titulaire: THALES, 92190 Meudon (FR)
(72) Inventeur: GERFAULT, Bertrand, Jouy en Josas 78530 (FR); BELLUOT, James, Versailles 78000 (FR)
(74) Mandataire: Atout PI Laplace
(86) Numéro de dépôt international: PCT/EP2021/065508
(87) Numéro de publication internationale: WO 2021/250118

(56) Documents cités:
- EP-A1- 2 869 396
- EP-A1- 3 404 766
- EP-A2- 0 491 505
- US-A1- 2011 002 031

## Description

L'invention porte sur un amplificateur hyperfréquences de puissance à état solide et combineur de puissance comprenant quatre tels amplificateurs à état solide.

L'invention se situe dans le domaine des amplificateurs hyperfréquences de puissance à état solide ou SSPA pour acronyme de "Solid State Power Amplifier" en langue anglaise.

Il est connu des systèmes d'amplification, tels des SSPA et des tubes à ondes progressives (d'acronyme TOP) ou TWTA pour acronyme de "Traveling-Wave Tube Amplifier" en langue anglaise, à combinaison spatiale ou classique présentant toutes des inconvénients majeurs.

En effet, ces systèmes d'amplification présentent des problèmes de compacité, de rendement, de réparation, de maintenabilité, d'assemblage, de coût d'assemblage et d'évolution, d'évolutivité et limitation en puissance.

Il est connu des amplificateurs à tube ou tubes à ondes progressives TWTA qui utilisent un filament chauffé, produisant une libération d'électrons par émission thermo-ionique. Ces électrons sont ensuite accélérés dans le vide par le biais d'un champ électrique de forte intensité généré par une très haute tension THT. Une fois accélérés, ces électrons sont focalisés dans un faisceau qui interagit avec une onde hyperfréquence. Progressivement, l'énergie continue, ou DC pour acronyme de "Direct Current" en langue anglaise, contenue dans le faisceau d'électrons est peu à peu convertie en énergie hyperfréquences à mesure que les électrons parcourent la ligne d'interaction. Cette énergie est alors transmise en dehors du tube alors que le résiduel d'énergie est transmis au collecteur et dissipé en chaleur.

Ces amplificateurs sont de bonne capacité et de haut rendement, mais fonctionnement en tout ou rien, et en cas de panne, le produit est hors d'usage. Ils nécessitent une très haute tension THT, une haute technicité, sont très onéreux à produire, et très difficile à maintenir.

Il est également connu des amplificateurs à état solide SSPA monolithiques combinés spatialement par le biais de lignes antipodales de type Vivaldi qui rayonneront ensuite dans des cavités.

Ces cavités constituent les points d'entrées d'un combineur à cavité conique. Ce type d'amplificateur, par exemple décrit dans le document US 10 340 574 B2, présentent une bonne compacité, des pertes assez faibles, et une absence de problèmes d'interconnexions inter-étages. Cependant, ils présentent une combinaison radiale qui rend très complexe la gestion de la dissipation thermique et complexe, et quasi impossible le fonctionnement de manière optimale en mode pulsé car les capacités de réserve d'énergie ne peuvent être placées au plus proche des circuits intégrés monolithiques hyperfréquences ou MMIC pour acronyme de "Monolithic Microwave Integrated Circuit" en langue anglaise.

Il est également connu des amplificateurs à état solide SSPA en combinaison hybride ou en T, dans lesquels des circuits intégrés monolithiques hyperfréquences MMIC sont combinés par le biais de coupleurs hybrides, wilkinson ou jonctions en T.

De tels amplificateurs sont relativement peu onéreux, mais présentent cependant des pertes relativement élevées, une absence d'évolutivité possible (limitation en puissance), une réparabilité très difficile du fait de l'assemblage type de type puce et fils ou "chip and wire" en langue anglaise.

Aucune des solutions existantes mentionnées précédemment n'est donc satisfaisante car elles présentent toutes des défauts majeurs.

Il est également connu le document de thèse 2014LIMO0072 qui divulgue les techniques de couplage connues, et notamment :
- un combineur Wilkinson dont la puissance est limitée par les pistes et la dégradation douce n'est pas possible car il est très difficile de refroidir les résistances d'équilibrage qui ne sont pas référencées à la masse. La dégradation douce permet à un amplificateur à état solide de continuer à fonctionner donc fournir de la puissance lorsqu'un des amplificateurs est en panne. Mais pour qu'il puisse fonctionner, il faut que la combinaison de puissance en sortie assure l'isolation entre les voies. Le signal d'un premier amplificateur ne doit pas être redirigé vers un deuxième amplificateur. Cette isolation est assurée en autre pas les résistances d'équilibrage. De plus ces résistances doivent être dimensionnées en tenue en puissance pour tenir la moitié de la puissance d'une voie. Elles doivent donc être parfaitement refroidies ;
- un combineur Gisel dont la puissance est limitée par les pistes et la largeur de sa bande passante est limitée ;
- un combineur radial dont le volume est important car la sortie du signal hyperfréquence n'est pas dans le même plan que les entrées ; et
- un combineur spatial dont le volume est important et son refroidissement est difficile car il est circulaire et les sources de chaleur (transistors) ne sont pas sur le même plan.

Les documents US 2011/002031 A1, EP 3 404 766 A1, EP 2 869 396 A1 et EP 0 491 505 A2 décrivent des systèmes combinateurs reliés avec un dispositif Té magique.

Un but de l'invention est de pallier les problèmes précédemment cités, et notamment faciliter la réparabilité, la compacité et l'évolutivité.

Aussi, il est proposé, selon un aspect de l'invention, un système combineur de puissance comprenant quatre amplificateurs de puissance hyperfréquences à état solide, reliés en H par un dispositif Té magique monobloc, dans lequel le dispositif Té magique monobloc comprend une bride en S et un support comprenant une partie inférieure intégrée du dispositif Té magique.

Un tel système combineur de puissance a une réparabilité, une compacité et une évolutivité améliorées.

Ainsi, grâce à l'aspect monobloc, sa fabrication est facilitée et de coût limité. Il est aussi plus facile à refroidir car tous les éléments sont dans le même plan et à connecter mécaniquement et thermiquement au dissipateur thermique.

La bride en S, permet au T2 magique de se raccorder directement sur une bride de connexion standard de type WRD650.

Le support comprenant une partie inférieure intégrée du dispositif Té magique améliore la gestion de la thermique, simplifie l'assemblage, améliore la compacité et le rendement en puissance du fait des faibles pertes.

Dans un mode de réalisation, le système combineur de puissance comprend un support comprenant un coupleur bi-directif.

Un tel mode de réalisation améliore la gestion de la thermique, simplifie l'assemblage, améliore la compacité et le rendement en puissance du fait des faibles pertes.

Selon un mode de réalisation, le support comprend une partie inférieure intégrée du coupleur bi-directif.

Ainsi, le coupleur directif s'intègre complètement dans l'espace sans ajouter de volume au système. La connexion se fait directement dans le guide sans composants d'interconnexion et donc sans perte d'énergie.

Dans un mode de réalisation, le système combineur de puissance comprend un module préamplificateur configuré pour amplifier et diviser le signal hyperfréquence à l'identique vers les quatre amplificateurs à état solide.

Le module préamplificateur est intégré sans perte de volume et la gestion de la précision de la division (amplitude et phase) peut être contrôlée électroniquement et numériquement au niveau de ce module.

Selon un mode de réalisation, les amplificateurs, le dispositif Té magique, le coupleur bi-directif et le module conducteur sont montés à plat sur le support.

La configuration de montage à plat des éléments du système combineur permet une gestion aisée de la thermique et des contraintes multi-missions.

Dans un mode de réalisation, le montage à plat comprend des vis.

Le montage à plat permet de limiter les interfaces thermiques entre les points chauds et la plaque froide qui assure le refroidissement de l'ensemble. Cela permet aussi d'avoir un accès facile à tous les sous-ensembles et améliore donc la réparabilité.

L'invention sera mieux comprise à l'étude de quelques modes de réalisation décrits à titre d'exemples nullement limitatifs et illustrés par le dessin annexé sur lequel :
[Fig.1] illustre schématiquement un amplificateur de puissance hyperfréquences à état solide, selon un aspect de l'invention ;
[Fig.2] illustre schématiquement un amplificateur de puissance hyperfréquences à état solide, selon un autre aspect de l'invention ;
[Fig.3] illustre schématiquement un amplificateur de puissance hyperfréquences à état solide, selon un autre aspect de l'invention ; et
[Fig.4] illustre schématiquement un amplificateur de puissance hyperfréquences à état solide, selon la figure 3.

Sur l'ensemble des figures, les éléments ayant des références identiques sont similaires.

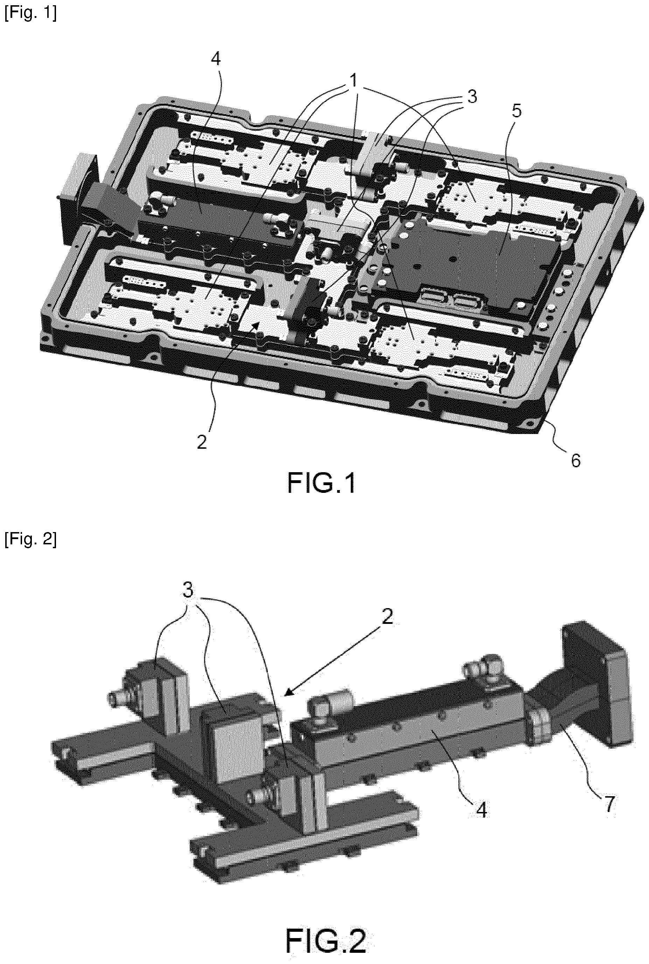

Sur la figure 1 est illustré, selon un aspect de l'invention, un système combineur de puissance comprenant quatre amplificateurs 1 de puissance hyperfréquences à état solide, reliés en H par un dispositif Té magique 2.

Le dispositif Té magique 2, dit 4 vers 1 (4 entrées / 1 sortie), comprend, par exemple, trois combineurs 3 dits deux vers un et quatre transitions coaxiales. Le système combineur de puissance comprend également un coupleur bidirectionnel 4.

Le Coupleur bidirectionnel 4 est un élément hyperfréquence qui est composé de quatre ports. Il comprend donc un premier port d'entrée, un deuxième port de sortie (transmission), un troisième port de mesure par couplage de l'onde hyperfréquence qui se propage du premier port d'entrée au deuxième port de sortie (onde incidente) et un quatrième port de mesure par couplage de l'onde qui se propage du deuxième port vers le premier port (onde réfléchie). Le couplage est le coefficient de prélèvement de l'onde entre les quatre ports respectivement. Quand on parle par exemple d'un coupleur directionnel -20dB cela signifie que le couplage de l'onde est 1/100 de l'onde principale. On parle aussi du port d'isolation car quand l'onde se propage du premier port au deuxième port il n'y a pas de couplage dans le quatrième port, il est isolé.

Le système combineur comprend en outre un module conducteur 5 ou "driver" en langue anglaise, utilisé pour amplifier et diviser le signal hyperfréquence vers quatre voies (une voie par amplificateurs 1 de puissance hyperfréquences). Les quatre voies doivent être rigoureusement identiques pour que la sommation par le combineur de sortie se fasse avec le minimum de pertes de puissance.

Le système combineur comprend également un boîtier 6 qui accueille et protège les éléments du système, et un couvercle non représenté peut permettre de fermer et finir de protéger le système.

La configuration en H du système combineur permet une optimisation de la surface d'encombrement ainsi que la répartition des points chauds.

Le dispositif Té magique 2, le coupleur bi-directif 4 et le module préamplificateur 5 peuvent être montés à plat sur un support, en l'espèce le boîtier 6. Le montage à plat peut comprendre des vis. La configuration de montage à plat des éléments du système combineur permet une gestion aisée de la thermique et des contraintes multi-missions. En effet, des condensateurs réservoirs peuvent alors être au plus près des amplificateurs de puissance hyperfréquences à état solide 1 pour le mode pulsé, car pour que la puissance reste constante pendant l'impulsion il faut des condensateurs de fortes valeurs (mF) donc gros. Le fait d'avoir une structure plate facilite leurs intégrations.

Au moins un amplificateur à état solide 1 peut comprendre au moins une interconnexion, entre une micropiste et une arête d'impédance adaptée de guide d'onde, munie d'un dispositif de serrage. Les transitions micropiste vers guide double arête avec transformation d'impédance hors standard permettent une compacité optimale sans transition; les pertes sont donc limitées et le rendement amélioré.

La figure 2 illustre le dispositif Té magique 2, comprenant trois combineurs 3 deux vers un, le coupleur bidirectionnel 4, et une bride en S 7.

Les amplificateurs 1 de puissance hyperfréquences et le dispositif Té magique 2 s'assemblent et se démontent très facilement par simple vissage. Les opérations de maintenance et réparabilité sont ainsi grandement facilitées.

Les interconnexions du système combineur ne sont pas hyperstatiques.

La conception modulaire permet une évolutivité à moindre coût en plus de la maintenabilité aisée.

Le système combineur offre une isolation entre voies qui permet la tenue de performance de la dégradation douce. L'isolation entre les voies est assurée par les résistances d'équilibrage du T Magic. Ces résistances doivent pouvoir supporter, si un amplificateur de puissance hyperfréquences devient défaillant, la moitié de la puissance d'un autre amplificateur de puissance hyperfréquences. Elles doivent donc pouvoir être refroidies et donc connectées mécaniquement et thermiquement à la plaque froide.

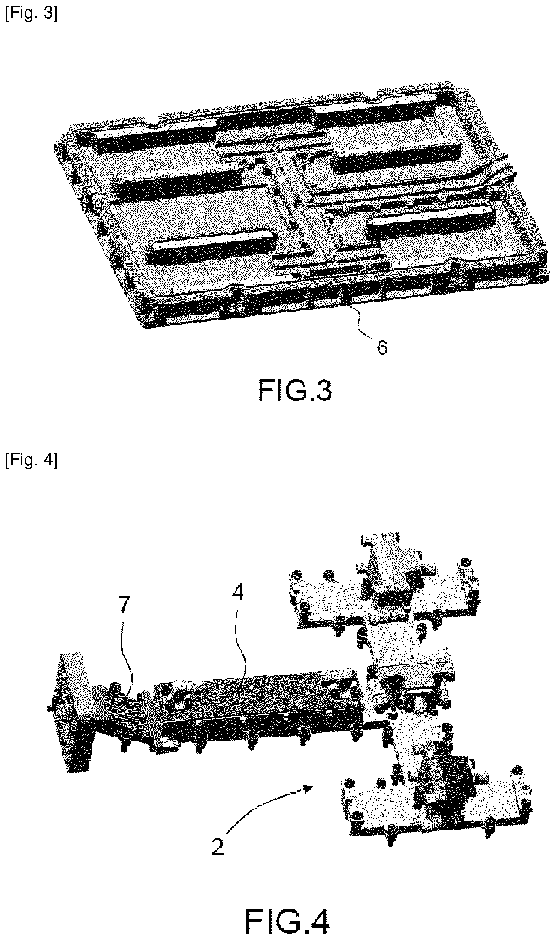

La figure 3 illustre un mode de réalisation dans lequel le support 6 comprend une partie inférieure intégrée du dispositif Té magique 2. En outre, le support 6 peut comprendre une partie inférieure intégrée du coupleur bi-directif 4.

La figure 4, illustre, dans le mode de réalisation de la figure 3, la partie supérieure vissée au support 6, du dispositif Té magique 2 et du coupleur bi-directif 4.

Ainsi le système combineur offre une excellente gestion de la thermique, un assemblage simple, une grande compacité et permet la tenue d'un rendement en puissance optimal du fait des faibles pertes.

## Revendications

1. Système combineur de puissance comprenant quatre amplificateurs de puissance hyperfréquences à état solide (1), reliés en H par un dispositif Té magique (2) monobloc, dans lequel le dispositif Té magique (2) monobloc comprend une bride en S (7) et un support (6) comprenant une partie inférieure intégrée du dispositif Té magique (2).

2. Système combineur de puissance selon la revendication 1, comprenant un coupleur bi-directif (4).

3. Système combineur de puissance selon la revendication 2, dans lequel le support (6) comprend une partie inférieure intégrée du coupleur bi-directif (4).

4. Système combineur de puissance selon l'une des revendications précédentes, comprenant un module préamplificateur (5) configuré pour amplifier et diviser le signal hyperfréquence à l'identique vers les quatre amplificateurs à état solide (1).

5. Système combineur de puissance selon la revendication 4, dans lequel les amplificateurs (1) à état solide, le dispositif Té magique (2), le coupleur bi-directif (4) et le module préamplificateur (5) sont montés à plat sur le support (6).

6. Système combineur de puissance selon la revendication 5, dans lequel le montage à plat comprend des vis.

## Patentansprüche

1. Leistungskombinierersystem, umfassend vier Festkörper-Mikrowellenfrequenz-Leistungsverstärker (1), die in H-Form durch eine einstückige Magic-T-Vorrichtung (2) verbunden sind, wobei die einstückige Magic-T-Vorrichtung (2) einen S-Flansch (7) und einen Träger (6) umfasst, der einen integrierten unteren Abschnitt der Magic-T-Vorrichtung (2) umfasst.

2. Leistungskombinierersystem nach Anspruch 1, umfassend einen bidirektionalen Koppler (4).

3. Leistungskombinierersystem nach Anspruch 2, wobei der Träger (6) einen integrierten unteren Abschnitt des bidirektionalen Kopplers (4) umfasst.

4. Leistungskombinierersystem nach einem der vorhergehenden Ansprüche, umfassend ein Vorverstärkermodul (5), das so konfiguriert ist, dass es das Mikrowellenfrequenz-Signal in identischer Weise verstärkt und an die vier Festkörperverstärker (1) aufteilt.

5. Leistungskombinierersystem nach Anspruch 4, wobei die Festkörperverstärker (1), die Magic-T-Vorrichtung (2), der bidirektionale Koppler (4) und das Vorverstärkermodul (5) flach auf dem Träger (6) montiert sind.

6. Leistungskombinierersystem nach Anspruch 5, wobei die Flachmontage Schrauben umfasst.

## Claims

1. A power combiner system comprising four microwave frequency solid-state power amplifiers (1), which are connected in an H configuration by a monobloc magic tee device (2), wherein the monobloc magic tee device (2) comprises an S-flange (7) and a support (6) comprising an integrated lower portion of the magic tee device (2).

2. The power combiner system according to claim 1, comprising a bidirectional coupler (4).

3. The power combiner system according to claim 2, wherein the support (6) comprises an integrated lower portion of the bidirectional coupler (4).

4. The power combiner system according to one of the preceding claims, comprising a preamplifier module (5) configured to amplify and divide the microwave frequency signal identically toward the four solid-state amplifiers (1).

5. The power combiner system according to claim 4, wherein the solid-state amplifiers (1), the magic tee device (2), the bidirectional coupler (4) and the preamplifier module (5) are mounted flat on the support (6).

6. The power combiner system according to claim 5, wherein the flat mounting comprises screws.
